# DEMANDE DE BREVET EUROPEEN

(11) **EP 1 545 174 A2**
(43) Date de publication de la demande: **22.06.2005**
(21) Numéro de dépôt: 04300917.4
(22) Date de dépôt: 17.12.2004
(51) Int. Cl.: H05K 3/34

(54) **Procédé pour braser un composant électronique sur une carte électronique, procédé de réparation de la carte et installation pour la mise en oeuvre du procédé**

(30) Priorité: 19.12.2003 FR 0315110
(71) Demandeur: Hispano Suiza, 92700 Colombes (FR)
(72) Inventeur: Glever, Bernard, 77370, Nangis (FR); Henry, Erick, 77390, Ozouer (FR); Chenot, José, 92370, Chaville (FR)
(74) Mandataire: David, Daniel

(57) **Abrégé**

L'invention porte sur un procédé pour braser un composant électronique (10) sur un support (20) comportant au moins un drain thermique (22) pour ledit composant, au moyen d'une pâte à braser incorporant un flux décapant activé à une première température, et un alliage de brasure fondant à une seconde température. Le procédé est caractérisé par le fait qu'il consiste à
- préchauffer le support (20) sur la face opposée au composant par le drain thermique (22) jusqu'à ladite première température,
- placer le composant sur le support avec la pâte à braser,
- chauffer le composant (10) en appliquant un gaz chaud à une température suffisante pour amener l'alliage de la brasure à la température de fusion.

L'invention porte aussi sur une installation de mise en oeuvre du procédé. Elle permet aussi la réparation d'une carte électronique par remplacement des éléments défectueux sans risque de débraser ou d'endommager les éléments voisins.

## Description

La présente invention se rapporte au domaine des cartes électroniques et en particulier aux moyens permettant d'assurer le montage de leurs composants par soudage.

Une carte électronique comprend globalement un support plan, en forme de carte réalisée dans un matériau électriquement isolant. Les composants électroniques sont montés sur ce support et comprennent des moyens de connexion électrique par brasage à des éléments conducteurs qui y sont intégrés. Le support est communément désigné dans le domaine par le sigle PCB (pour printed circuit board)

Les composants conventionnels, qui sont du type à sorties périphériques c'est à dire dont les pattes de connexion sont disposées à la périphérie du boîtier contenant la puce électronique, peuvent être aisément soudés au substrat. On peut apporter la chaleur nécessaire à la fusion de la brasure et au brasage en approchant la source de chaleur des pattes périphériques sans risquer d'endommager le composant par un chauffage excessif.

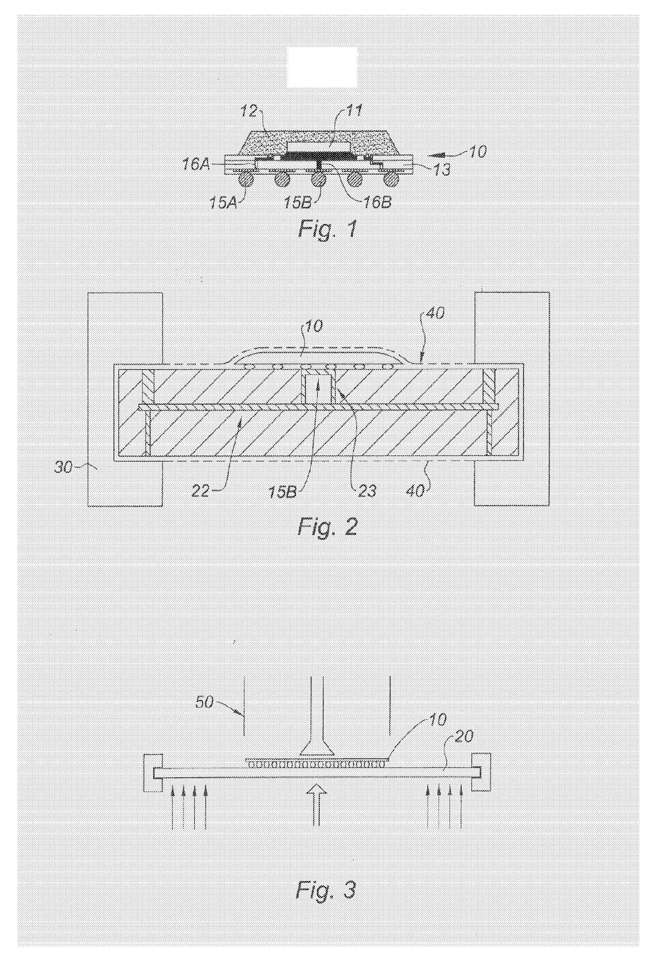

L'évolution technologique permet maintenant l'emploi de composants plus compacts, à sorties dites surfaciques. On a représenté sur la figure 1 un schéma d'un composant 10 de type désigné dans le domaine par BGA (pour ball grid array). Le composant comprend une puce électronique 11 noyée dans un matériau d'encapsulation 12, et sur le dessous un substrat 13. Des billes de report 15 sont solidaires du substrat sur l'autre côté et sont disposées en une grille. Une partie des billes 15A est reliée électriquement à la puce 11 par des moyens de connexion électriques 16A appropriés. Certaines billes 15B, localisées dans la partie centrale du substrat, sont reliées électriquement et thermiquement à la puce par des moyens de connexion 16B pour en drainer les calories.

Par rapport aux composants à sorties périphériques, l'emploi de composants à sorties surfaciques présente cependant l'inconvénient de nécessiter leur chauffage pour en réaliser la brasure car les billes ne sont pas accessibles autrement. Pour braser ou débraser de tels composants, il est ainsi nécessaire de les chauffer à la température de brasage, qui est de 215°C. On doit s'assurer que la température reste inférieure à celle de tenue de la puce qui est de 250°C.

En outre, dans certaines applications, aéronautiques par exemple, les cartes électroniques sont enfermées dans des boîtiers dans lesquels ne circule aucun air de refroidissement. On équipe alors le support, désigné PWB, de drains thermiques métalliques par lesquels la chaleur est évacuée jusque vers la peau du boîtier dans lequel la carte électronique est contenue. On a représenté sur la figure 2 le montage d'un composant à sorties surfaciques 10 sur un support de type PWB 20. L'ensemble est contenu dans un boîtier 30 métallique. Le support 20 comprend des drains métalliques 22 en cuivre par exemple, qui sont en contact par des moyens de connexion thermiques 23 avec les aires thermiques 15B du composant 10. Les drains sont aussi thermiquement en contact avec le boîtier 30. La chaleur est ainsi évacuée par conduction thermique à travers la paroi du boîtier. Par ailleurs pour les applications aéronautiques en particulier, un vernis climatique 40 recouvre l'ensemble de la carte, et la protège de l'humidité.

En raison du coût élevé des cartes électroniques dans certaines applications, notamment aéronautiques, il est important de pouvoir les réparer en remplaçant les composants défectueux. Le remplacement doit être effectué sans perturber les composants voisins. Une étape délicate consiste à apporter localement une quantité de chaleur suffisante pour entraîner la fusion de la brasure du seul composant à remplacer.

La présence des drains thermiques et du vernis climatique constitue dans ce contexte un inconvénient lorsqu'il s'agit de démonter un tel composant de son support, et de braser un nouveau composant.

On a représenté sur la figure 3, une installation de l'art antérieur permettant le démontage d'un composant à sorties surfaciques 10 de son support 20. Sur le dessus, de l'air chaud est dirigé en direction du composant par le moyen d'une buse 50. Celle-ci est équipée d'une pipette d'aspiration pour le retrait du composant après mise en fusion de la brasure. Eventuellement, le chauffage peut être assuré par un rayon laser. On apporte le maximum d'énergie par le dessous du support, soit en insufflant de l'air chaud à une température de l'ordre de 300°C, soit par un chauffage infrarouge. Les installations de l'art antérieur ne sont pas satisfaisantes car les moyens de chauffage ne permettent pas d'éviter que l'on refonde les brasures des composants voisins et de ceux qui sont situés sous le composant à remplacer.

Par ailleurs, les solutions de l'art antérieur ne conviennent certainement pas pour braser un nouveau composant ou débraser un composant existant lorsque le support comprend des drains thermiques. On est obligé dans ce cas d'apporter une quantité de chaleur plus importante pour tenir compte de son évacuation par le drain. Cet excès de chaleur est dommageable pour les composants voisins. Par ailleurs, le vernis climatique est susceptible de fondre lui aussi à la température de chauffage. Il risque de migrer dans les brasures voisines et d'altérer les connexions électriques.

L'invention permet de résoudre les problèmes rapportés ci dessus.

Conformément à l'invention, le procédé pour braser un composant électronique sur un support comportant au moins un drain thermique pour le dit composant, au moyen d'une pâte à braser incorporant un flux décapant activé à une première température, et un alliage de brasure fondant à une seconde température supérieure à la première, est caractérisé par le fait qu'il comprend les étapes consistant à :
- préchauffer le support par le drain thermique jusqu'à ladite première température,
- placer le composant sur le support avec la pâte à braser,
- chauffer le composant en appliquant un gaz chaud à une température suffisante pour activer le flux et amener l'alliage de la brasure à la seconde température.

Une pâte à braser utilisée dans le procédé de l'invention comprend communément, un alliage de brasure sous la forme en général de billes, un flux d'activation très léger pour le traitement des surfaces, et un diluant ou solvant.

Grâce à l'invention, et en particulier par le chauffage à travers le drain thermique du support, on limite pendant le préchauffage l'apport de chaleur à celui nécessaire à l'activation du flux, la température du support et des composant voisins restant inférieure à celle de refusion de l'alliage de brasure de ces derniers. En outre, la chaleur nécessaire pour que l'alliage de brasure atteigne la température de fusion est apportée localement par la buse à gaz chaud au-dessus du composant.

Conformément à une autre caractéristique, le préchauffage est effectué par conduction thermique, au moyen d'une plaque chauffante mise en contact avec le drain thermique.

Ce mode de chauffage est particulièrement avantageux car il permet de maîtriser le flux de chaleur. En particulier, on dispose la plaque chauffante sous le support, du côté opposé au composant.

Conformément à une autre caractéristique, le chauffage par air chaud du composant comprend une étape de préchauffage à une température intermédiaire, inférieure à la seconde température.

Conformément à une autre caractéristique, on place la carte dans une enceinte au moins pendant l'étape de préchauffage, permettant d'homogénéiser les températures sur la carte.

Conformément à une autre caractéristique, on applique le gaz chaud au moyen d'une buse disposée perpendiculairement au plan de la carte, associée à un moyen formant cheminée de retour des gaz après balayage du composant.

L'invention porte également sur un procédé pour réparer une carte électronique incorporant un composant à changer brasé sur le support. Selon ce procédé on préchauffe le support par le drain thermique jusqu'à ladite première température, on chauffe le composant à changer en appliquant un gaz chaud à une température suffisante pour amener l'alliage de la brasure dudit composant à la seconde température, et on retire le composant.

Ce procédé de réparation présente l'avantage de permettre le retrait du composant sans créer de contrainte thermique sur la carte, susceptible d'endommager une partie de la carte. Plus particulièrement, on peut localiser l'apport de chaleur nécessaire à la fusion de l'alliage de brasure du composant à retirer sans que l'on endommage les liaisons des composants voisins ou situés sous le support.

L'invention porte également sur une installation d'assemblage et de réparation de cartes électroniques permettant la mise en oeuvre du ou des procédés précédents, comportant un moyen de fixation de ladite carte, un moyen pour le chauffage par conduction thermique sur un côté de la carte et un moyen pour le chauffage par gaz chaud sur l'autre côté de ladite carte.

Une telle installation permet à la fois la mise en oeuvre du procédé de brasage ci-dessus et d'assurer le débrasage d'un composant à remplacer sans affecter les composants voisins.

Conformément à une autre caractéristique le moyen de chauffage par conduction est constitué par une plaque chauffante sur laquelle on place la carte. En particulier, l'installation comporte des supports conducteurs thermiques à disposer entre la carte et la plaque chauffante.

Conformément à une autre caractéristique, l'installation comporte un capotage formant une enceinte d'équilibrage des températures pour la carte. En particulier, le capotage comporte au moins une ouverture pour permettre l'accès à l'un des dits composants par un moyen de chauffage par gaz chaud à buse. Plus précisément les bords de ladite ouverture sont équipés d'une paroi perpendiculaire à la carte de manière à ménager une cheminée de retour des gaz entre elle-même et les parois de la buse de chauffage par gaz chaud.

L'invention va maintenant être décrite plus en détail en référence aux dessins annexés sur lesquels,
- la figure 1 représente en coupe transversale le schéma d'un composant à sorties surfaciques,
- la figure 2 représente en coupe transversale le schéma d'une carte électronique avec drains thermique dans le support,
- la figure 3 représente schématiquement une installation de brasage de composant sur un support, selon l'enseignement de l'art antérieur,
- la figure 4 représente schématiquement une installation mettant en oeuvre le procédé de l'invention,
- la figure 5 montre un graphique illustrant un cycle de brasage.

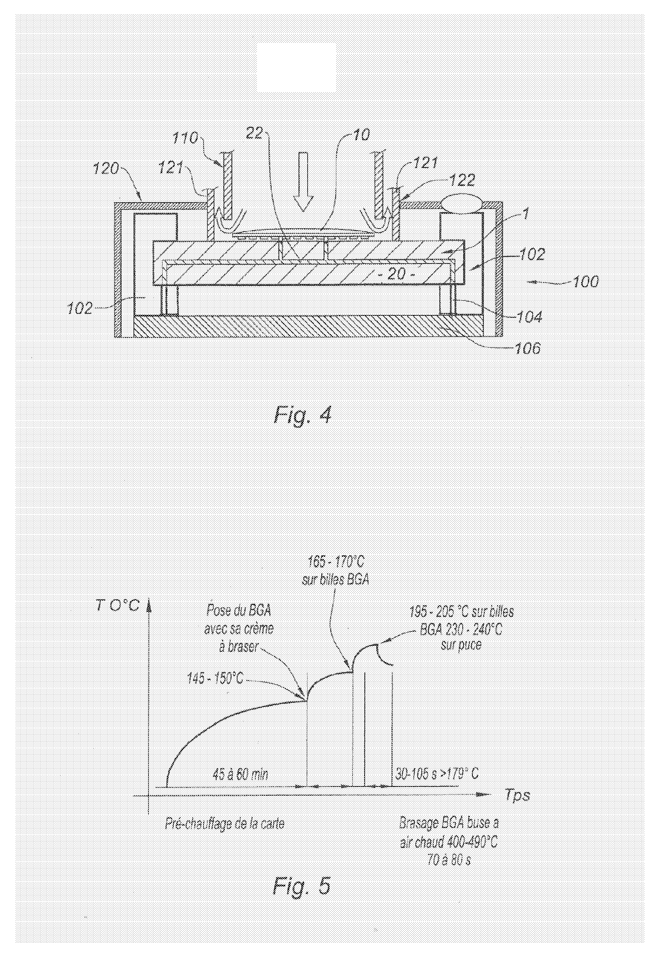

En se reportant à la figure 4, on voit une installation 100 d'assemblage et de réparation de cartes électroniques permettant le brasage ou le débrasage de composants électroniques sur un support, dans laquelle on a placé une carte électronique 1, avec son support 20 sur lequel est disposé le composant 10. Le support 20 est représenté avec son drain thermique 22. Le support est en contact par des plots 102 pourvus de drains thermiques 104 avec une plaque 106 chauffante. Les plots forment ainsi des supports conducteurs thermiques. Le moyen de chauffage de la plaque n'est pas représenté. Il peut être électrique par exemple. Sur le dessus de la carte on a disposé une buse 110 perpendiculairement au plan du support. La largeur de la buse 110 est suffisante pour couvrir le composant 10. Sur la figure sont représentés deux éléments de paroi 121 extérieurs aux parois de la buse et parallèles à son axe en ménageant un passage. Ils constituent une cheminée de retour des gaz. On a indiqué par des flèches la direction du gaz incident guidé par les parois de la buse et du même gaz après son impact contre le composant.

Avantageusement, on enveloppe l'ensemble de la carte et de la plaque chauffante dans une enceinte de protection thermique 120 dans le but de parvenir à bonne homogénéité en température des différents éléments qui la composent. Avantageusement, le capotage comporte des ouvertures 122 ménagées aux endroits où se situent les composants à braser ou à débraser, selon qu'il s'agit d'assembler une carte ou bien de la réparer en en changeant un composant. Ces ouvertures sont obstruées par exemples au endroits où l'on n'a pas à intervenir. Les éléments de paroi 121 sont par exemple placés le long des bords de l'ouverture 122 de manière à former une barrière aux gaz lorsqu'on place une buse de chauffage par l'ouverture. Les parois forment une cheminée avec les parois d'une buse que l'on place dans l'ouverture.

On décrit un cycle de brasage d'un composant spécifique en référence au graphique de la figure 5.
On procède au préchauffage de la carte pendant une durée qui va de 45 à 60 minutes au moyen de la plaque chauffante ; la chaleur produite par la plaque est transmise par les conducteurs 104 jusqu'aux éléments métalliques formant les drains thermiques de la carte. La montée en température est continue jusqu'à ce que la carte atteigne la température de 145°C à 150°C.
   On met ensuite en place le composant sur le support en interposant la pâte à braser. La température est suffisante pour activer le flux de décapage contenu dans la crème à braser.
   On insuffle de l'air chaud par la buse sur le composant à une température de 250°C à 300°C pendant 3 à 4 minutes. L'air balaie la surface supérieure du composant contourne le bord libre de la buse et est guidé par les parois de la cheminée en étant dévié à 180° par rapport à la direction initiale. La température au niveau des billes du composant atteint ainsi progressivement 165°C-170°C.
   On augmente alors la température de l'air chaud jusqu'à 400-490°C ; la température sur les billes monte progressivement à 195-205°C et celle de la puce à 230-240°C. La température de fusion de l'alliage constituant la brasure est atteinte. On arrête le flux d'air chaud.

Lors de la réparation d'une carte électronique, on procède avantageusement selon un cycle similaire ou, préférentiellement dans un but de simplification des modes opératoires, selon le même cycle que celui qui a été établi pour le brasage du composant concerné. En particulier on préchauffe la carte jusqu'à la première température afin que les contraintes crées dans la carte soient équilibrées.

On a procédé à des essais comparatifs entre une installation de l'art antérieur illustrée par la figure 3, avec chauffage par air chaud par la face inférieure, et l'installation de la figure 4.

Dans le premier cas, la dispersion des températures est importante lors du soudage d'un composant. Pour obtenir l'activation des flux de la brasure (130-150), on ne peut éviter que certaines zones autour et sous le composant soient portées à des températures proches du liquidus, et, que lors du pic de refusion les brasures des composants situés dans ces zones refusionnent.

Dans le second cas la température de préchauffage atteint sans difficulté la température d'activation des flux. Cependant on réduit sensiblement la dispersion des températures dans les différents points sur la carte quand on enferme la carte dans une enceinte de protection thermique.

## Revendications

1. Procédé pour braser un composant électronique (10), sur un support (20) comportant au moins un drain thermique (22) pour ledit composant, au moyen d'une pâte à braser incorporant un flux décapant activé à une première température, et un alliage de brasure fondant à une seconde température supérieure à la première, **caractérisé par le fait qu'**il comprend les étapes consistant à préchauffer le support (20) par le drain thermique (22) jusqu'à ladite première température, placer le composant sur le support (20) avec la pâte à braser, chauffer le composant (10) en appliquant un gaz chaud à une température suffisante pour amener l'alliage de la brasure à la seconde température.

2. Procédé selon la revendication précédente, selon lequel le préchauffage est effectué par conduction thermique, au moyen d'une plaque chauffante (106) mise en contact avec le drain thermique.

3. Procédé selon la revendication précédente, selon lequel on dispose la plaque chauffante (106) sous le support (20), du côté opposé au composant (10).

4. Procédé selon l'une des revendications précédentes, selon lequel le chauffage par gaz chaud du composant comprend une étape de préchauffage à une température intermédiaire, inférieure à la seconde température.

5. Procédé selon l'une des revendications précédentes, selon lequel on place la carte dans une enceinte (120) au moins pendant l'étape de préchauffage, permettant d'homogénéiser les températures sur la carte.

6. Procédé selon l'une des revendications précédentes selon lequel on applique le gaz chaud au moyen d'une buse (110) disposée perpendiculairement au plan de la carte, associée à un moyen formant cheminée de retour des gaz après balayage du composant.

7. Procédé pour réparer une carte électronique incorporant un composant à changer, brasé sur un support selon le procédé de l'une des revendications précédentes, selon lequel on préchauffe le support par le drain thermique jusqu'à ladite première température, on chauffe le composant à changer en appliquant un gaz chaud à une température suffisante pour amener l'alliage de la brasure dudit composant à la seconde température, et on retire le composant.

8. Installation d'assemblage et de réparation de cartes électroniques permettant la mise en oeuvre du procédé selon l'une des revendications précédentes, comportant un moyen de fixation de ladite carte (1), un moyen (106) pour le chauffage par conduction thermique sur un côté de la carte et un moyen (110) pour le chauffage par gaz chaud sur l'autre côté de ladite carte.

9. Installation selon la revendication précédente, dont le moyen de chauffage par conduction est constitué par une plaque chauffante (106) sur laquelle on place la carte.

10. Installation selon la revendication précédente, comprenant des supports (102) conducteurs thermiques à disposer entre la carte et la plaque chauffante (106).

11. Installation selon l'une des revendications 8 à 10, comportant un capotage (120) formant une enceinte d'équilibrage des températures pour la carte.

12. Installation selon la revendication 11, dont le capotage comporte au moins une ouverture (122) pour permettre l'accès à l'un des dits composants par un moyen (110) de chauffage par gaz chaud à buse.

13. Installation selon la revendication 12 dont les bords de ladite ouverture sont équipés d'une paroi (121) perpendiculaire à la carte de manière à ménager une cheminée de retour des gaz entre elle-même et les parois de la buse de chauffage par gaz chaud.
